# EUROPEAN PATENT APPLICATION

(11) **EP 4 633 309 A1**
(43) Date of publication of application: **15.10.2025**
(21) Application number: 25161463.2
(22) Date of filing: 04.03.2025
(51) Int. Cl.: H05K 7/20

(54) **FAN MODULE FOR AN ELECTRONIC DEVICE**

(30) Priority: 27.03.2024 CN 202410359718
(71) Applicant: Delta Electronics, Inc., Taoyuan City 333 (TW)
(72) Inventor: LIN, Chun-Han, 333 Taoyuan City (TW)
(74) Representative: Porta & Consulenti Associati S.p.A.

(57) **Abstract**

An electronic device includes a housing, a fan module, a partition, two heat sources, and an air guide assembly. The housing has an internal space and an opening communicated with each other. The fan module is fixed to an outside of the housing and configured to generate an airflow toward the opening. The partition is disposed in the internal space. The partition divides the internal space into first and second sub-spaces, and is configured to branch the airflow into first and second sub-airflows to the first and second sub-spaces, respectively. The two heat sources are respectively disposed in the first and second sub-spaces. The air guide assembly is disposed at the opening and includes a plurality of air guide blades. The air guide blades are configured to rotate to adjust air volumes of the first and second sub-airflows.

## Description

### BACKGROUND

### Technical Field

The present disclosure relates to an electronic device, and more particularly, to an electronic device including a fan module.

### Description of Related Art

Current cabinets are equipped with multiple power supply slots for inserting power supply modules. For example, a power adaptor is one of the common power supply modules, which converts the input voltage into various working voltages required for its operation. A corresponding number of power supply modules can be configured according to the load requirements of the equipment in the cabinet. The heat generated by the power supply modules is generally dissipated by fan modules, and the current fan modules cannot effectively cope with this situation, so the heat dissipation work cannot be performed efficiently.

Accordingly, how to provide an electronic device to solve the foregoing problem becomes an important issue to be solved by those in the industry.

### SUMMARY

An aspect of the disclosure is to provide an electronic device to solve the foregoing problem.

According to an embodiment of the disclosure, an electronic device includes a housing, a fan module, a partition, two heat sources, and an air guide assembly. The housing has an internal space and an opening communicated with each other. The fan module is fixed to an outside of the housing and is configured to generate an airflow toward the opening. The partition is disposed in the internal space of the housing. The partition divides the internal space into a first sub-space and a second sub-space, and is configured to branch the airflow into a first sub-airflow and a second sub-airflow to the first sub-space and the second sub-space, respectively. The two heat sources are respectively disposed in the first sub-space and the second sub-space. The air guide assembly is disposed at the opening and includes a plurality of air guide blades. The air guide blades are configured to rotate to adjust air volumes of the first sub-airflow and the second sub-airflow.

In one or more embodiments of the present disclosure, the air guide blades are sequentially arranged along a direction.

In one or more embodiments of the present disclosure, each of the air guide blades has a first end and a second end. The first end and the second end are adjacent to the fan module and the partition, respectively.

In one or more embodiments of the present disclosure, the second ends of the air guide blades are defined to form an air outlet area. The air outlet area has two heights relative to opposite sides of the partition, respectively, in a direction perpendicular to a length direction of the partition. The air guide blades are configured to rotate to adjust the two heights.

In one or more embodiments of the present disclosure, the electronic device further includes two temperature sensors, a driving member, and a controller. The two temperature sensors are disposed in the housing and are configured to detect temperatures of the two heat sources, respectively. The driving member is configured to rotate the air guide blades. The controller is configured to drive the driving member according to the temperatures of the two heat sources.

In one or more embodiments of the present disclosure, the second ends of the air guide blades define an air outlet area. The air outlet area has two heights relative to opposite sides of the partition, respectively, in a direction perpendicular to a length direction of the partition. The controller is configured to drive the driving member such that a difference percentage between the two heights is substantially equal to a difference percentage between the temperatures of the two heat sources.

In one or more embodiments of the present disclosure, the first end is pivotally connected to the housing. The air guide assembly further includes a linkage mechanism. The second end is pivotally connected to the linkage mechanism.

In one or more embodiments of the present disclosure, the air guide assembly further includes a driving member. The driving member is fixed to the housing and configured to move the linkage mechanism.

In one or more embodiments of the present disclosure, the driving member is configured to move along a first direction. The linkage mechanism includes a linkage and a bracket. The second end is pivotally connected to the linkage. The bracket is connected to the linkage and is configured to slide relative to the driving member along a second direction.

In one or more embodiments of the present disclosure, the bracket has a through hole. The driving member is slidably engaged with the through hole.

In one or more embodiments of the present disclosure, the driving member has two retaining protrusions. The bracket is slidably retained between the two retaining protrusions.

According to an embodiment of the disclosure, an electronic device includes a housing, a fan module, a partition, two heat sources, and an air guide assembly. The housing has an internal space and an opening communicated with each other. The fan module is fixed to an outside of the housing and is configured to generate an airflow toward the opening. The partition divides the internal space into a first sub-space and a second sub-space. The two heat sources are disposed in the first sub-space and the second sub-space, respectively. The air guide assembly is disposed at the opening and includes a plurality of air guide blades. Ends of the air guide blades adjacent to the partition define an air outlet area. The air outlet area has two heights relative to opposite sides of the partition, respectively, in a direction perpendicular to a length direction of the partition. The air guide blades are configured to rotate to adjust the two heights.

In one or more embodiments of the present disclosure, the electronic device further includes two temperature sensors, a driving member, and a controller. The two temperature sensors are disposed in the housing and are configured to detect temperatures of the two heat sources respectively. The driving member is configured to rotate the air guide blades. The controller is configured to drive the driving member according to the temperatures of the two heat sources.

In one or more embodiments of the present disclosure, the controller is configured to drive the driving member such that a difference percentage between the two heights is substantially equal to a difference percentage between the temperatures of the two heat sources.

In one or more embodiments of the present disclosure, the air guide assembly further includes a linkage mechanism. The ends of the air guide blades adjacent to the partition are pivotally connected to the linkage mechanism.

Accordingly, in the electronic device of the present disclosure, before the airflow generated by the fan module reaches the two heat sources respectively disposed in the first sub-space and the second sub-space, the air guide blades of the air guide assembly can rotate to adjust the air volumes of the first sub-airflow and the second sub-airflow entering the first sub-space and the second sub-space respectively, thereby efficiently dissipating heat in response to the heat of the two heat sources. In addition, the controller can control the driving member to adjust the air outlet area of the air guide blades according to the temperatures of the two heat sources (obtained by the two temperature sensors), thereby achieving the effect of automatically dissipating heat in response to the heat of the two heat sources.

It is to be understood that both the foregoing general description and the following detailed description are by examples, and are intended to provide further explanation of the disclosure as claimed.

### BRIEF DESCRIPTION OF THE DRAWINGS

The disclosure can be more fully understood by reading the following detailed description of the embodiment, with reference made to the accompanying drawings as follows:
Fig. 1 is a perspective view of an electronic device according to an embodiment of the present disclosure;
Fig. 2 is a cross-sectional view of the electronic device according to an embodiment of the present disclosure;
Fig. 3 is another cross-sectional view of the electronic device shown in Fig. 2;
Fig. 4 is a partial perspective view of some components of the electronic device shown in Fig. 1;
Fig. 5 is another partial perspective view of some components of the electronic device shown in Fig. 1; and
Fig. 6 is a functional block diagram of some components of the electronic device shown in Fig. 1.

### DETAILED DESCRIPTION

Reference will now be made in detail to the present embodiments of the disclosure, examples of which are illustrated in the accompanying drawings. Wherever possible, the same reference numbers are used in the drawings and the description to refer to the same or like parts. However, specific structural and functional details disclosed herein are merely representative for purposes of describing example embodiments, and thus may be embodied in many alternate forms and should not be construed as limited to only example embodiments set forth herein. Therefore, it should be understood that there is no intent to limit example embodiments to the particular forms disclosed, but on the contrary, example embodiments are to cover all modifications, equivalents, and alternatives falling within the scope of the disclosure.

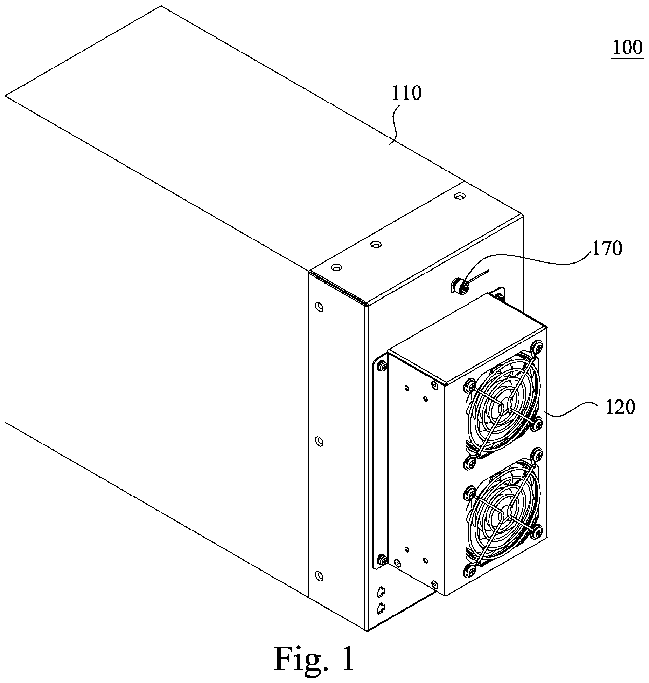

Reference is made to Fig. 1. Fig. 1 is a perspective view of an electronic device 100 according to an embodiment of the present disclosure. As shown in Fig. 1, the electronic device 100 includes a housing 110 and a fan module 120. A driving member 170 is selectively disposed on the housing 110. The driving member 170 is connected to components in the housing 110 and used to drive these components. The connection and driving methods between the driving member 170 and these components will be described in detail below.

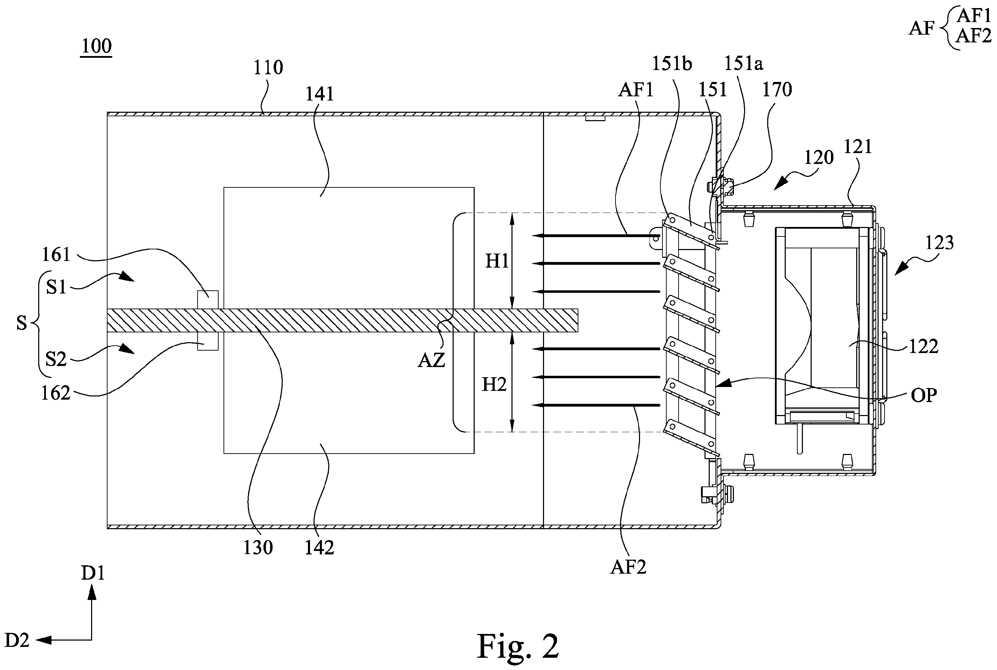

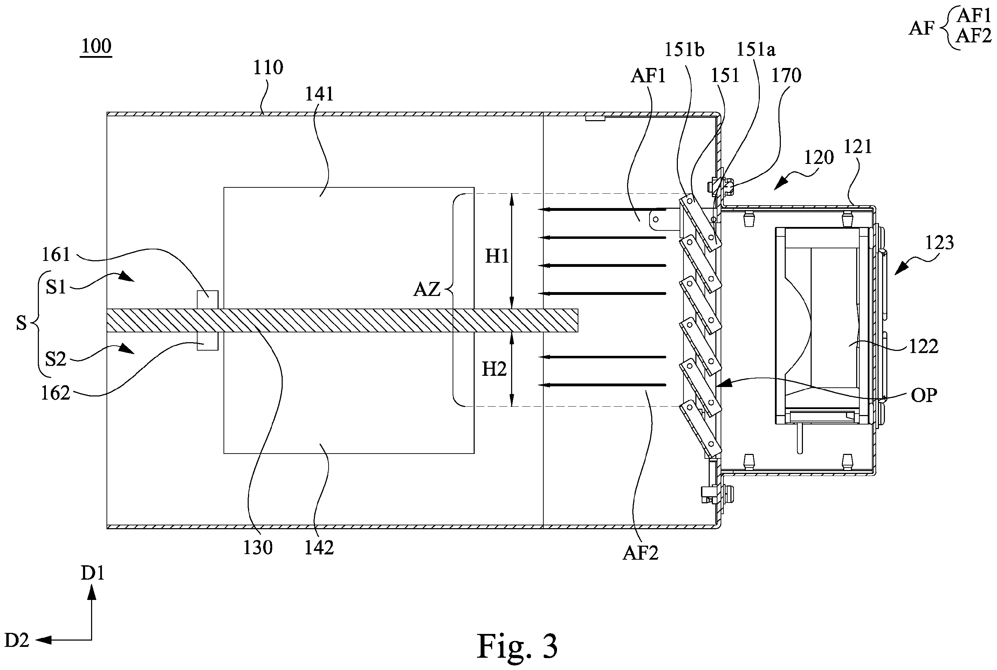

Reference is made to Fig. 2 and Fig. 3. Fig. 2 is a cross-sectional view of the electronic device 100 according to an embodiment of the present disclosure. Fig. 3 is another cross-sectional view of the electronic device 100 shown in Fig. 2. As shown in Figs. 2 to 3, the electronic device 100 further includes a partition 130 and two heat sources 141, 142. The housing 110 has an internal space S and an opening OP communicated with each other, and the opening OP is communicated with an outside of the housing 110. The fan module 120 is fixed to the outside of the housing 110 and is configured to generate an airflow AF toward the internal space S of the housing 110 via the opening OP. The partition 130 is disposed in the internal space S. The partition 130 divides the internal space S into a first sub-space S1 and a second sub-space S2, and is configured to branch the airflow AF into a first sub-airflow AF1 and a second sub-airflow AF2 to the first sub-space S1 and the second sub-space S2, respectively. The two heat sources 141, 142 are disposed in the first sub-space S1 and the second sub-space S2, respectively.

For example, at least one of the two heat sources 141, 142 may be a power supply module. In general, under different working conditions, the power board of the power supply module will have different proportions of heat loss, thereby generating different amounts of heat. The two heat sources 141, 142 may be a primary side and the secondary side of a transformer, respectively, but is not limited to this.

As shown in Fig. 2 and Fig. 3, the electronic device further includes an air guide assembly 150. The air guide assembly 150 is disposed at the opening OP in the housing 110 and includes a plurality of air guide blades 151. The air guide blades 151 generally cover the area of the opening OP. After the airflow AF flowing into the internal space S from the opening OP passes through the air guide blades 151, it flows through the partition 130 to generate the first sub-airflow AF1 and the second sub-airflow AF2. The rotation of the air guide blades 151 can cause the first sub-airflow AF1 and the second sub-airflow AF2 generated by flowing through the partition 130 to produce air volume changes in different proportions. Under the premise that the heat dissipation effect is positively correlated with the air volume, the air volume ratio can be adjusted according to the difference in heat between the two heat sources 141, 142 to efficiently dissipate heat.

In detail, the air guide blades 151 are sequentially arranged along a direction D1. For example, the plurality of air guide blades 151 are arranged substantially equidistantly in the direction D1, and the plurality of air guide blades 151 are substantially parallel to each other. Each of the air guide blades 151 has a first end 151a and a second end 151b. The first end 151a and the second end 151b are adjacent to the fan module 120 and the partition 130, respectively. The first end 151a of said each of the air guide blades 151 is pivotally connected to the housing 110. Therefore, when said each of the air guide blades 151 rotates around the first end 151a, the second end 151b will swing relative to the first end 151a to change its position. The airflow AF generated by the fan module 120 toward the opening OP will first reach the first ends 151a of the air guide blades 151, then pass through gaps between the air guide blades 151 and be guided by the air guide blades 151, and then leave from the second ends 151b of the air guide blades 151 to flow to the two heat sources 141, 142 disposed in the internal space S of the housing 110. The air guide blades 151 of the air guide assembly 150 are similar to the blades of a blind. The air guide blades 151 may be metal sheets, but is not limited to this.

In some embodiments, the direction D1 is substantially perpendicular to a length direction of the partition 130, but the present disclosure is not limited thereto.

Under the aforementioned need to adjust the air volume ratio, the angle formed by the inclination of the air guide blades 151 relative to the direction D1 is an acute angle. The air guide blades 151 may rotate perpendicular to the direction D1.

As shown in Fig. 2 and Fig. 3, the second ends 151b of the air guide blades 151 define an air outlet area AZ. For example, the air outlet area AZ of the air guide blades 151 may be defined by the area between the second ends 151b of the two air guide blades 151 arranged at the outermost sides (i.e., the upper and lower sides in Fig. 2 and Fig. 3). The air outlet area AZ has two heights H1, H2 relative to opposite sides of the partition 130, respectively, in the direction D1 perpendicular to the length direction of the partition 130. Under the need to adjust the air volume ratio, the air guide blades 151 are configured to rotate to adjust the two heights H1, H2. By rotating the air guide blades 151 to adjust the heights H1, H2, the position of the air outlet area AZ of the air guide blades 151 in the direction D1 can be adjusted, thereby achieving the purpose of adjusting the air volume of the first sub-airflow AF1 and the second sub-airflow AF2 entering the first sub-space S1 and the second sub-space S2, respectively.

As shown in Fig. 2 and Fig. 3, the fan module 120 includes a casing 121, a fan 122, and an air inlet 123. The casing 121 generally covers the opening OP of the housing 110. The fan 122 is disposed in the casing 121. When the fan 122 rotates, the external airflow is introduced into the opening OP through the air inlet 123. In the present embodiment, the fan 122 is an axial flow fan or a diagonal flow fan. A centrifugal fan may also be configured due to changes in the position of the air inlet 123.

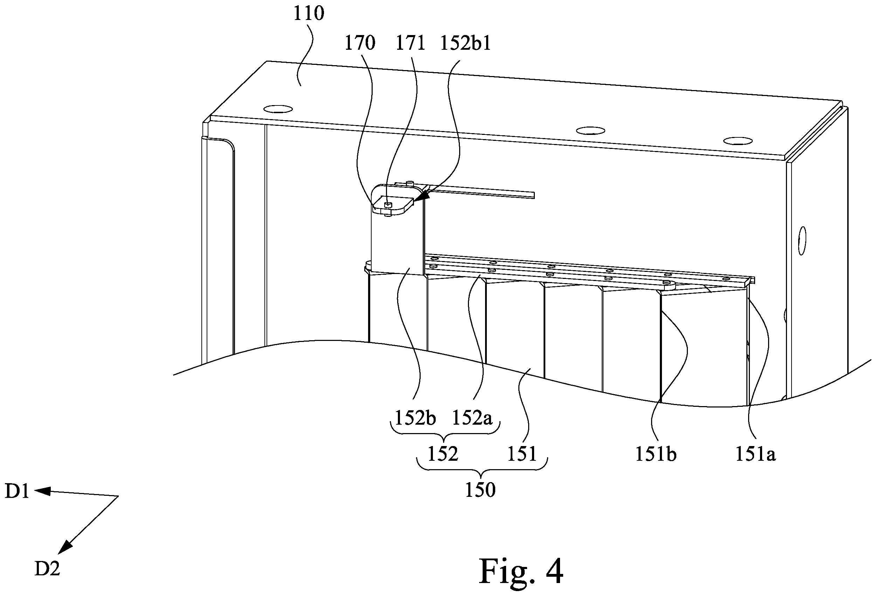

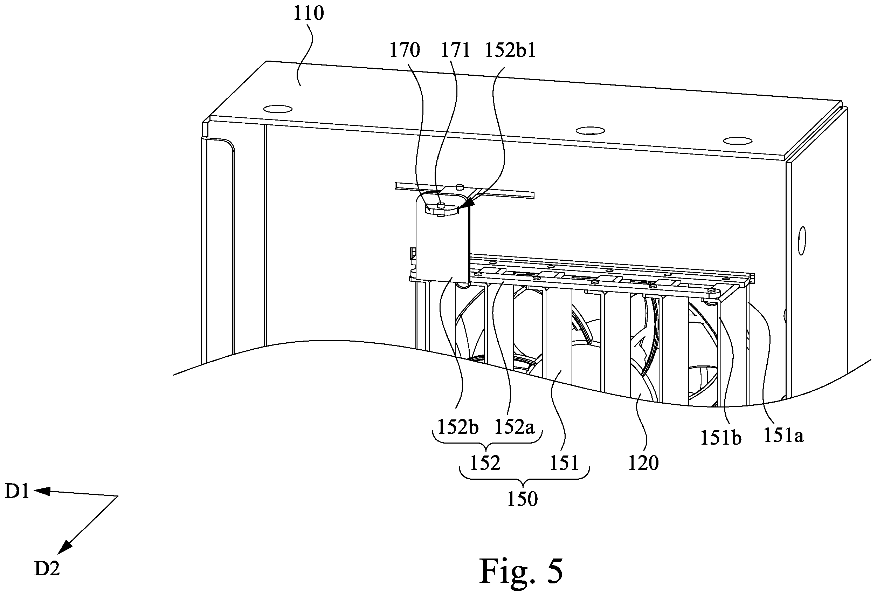

Fig. 4 is a partial perspective view of some components of the electronic device 100 shown in Fig. 1. Fig. 5 is another partial perspective view of some components of the electronic device 100 shown in Fig. 1. Reference is made to Fig. 4 and Fig. 5 together, the air guide assembly 150 further includes a linkage mechanism 152. The second ends 151b of the air guide blades 151 are pivotally connected to the linkage mechanism 152. By moving the linkage mechanism 152, all the air guide blades 151 can rotate synchronously. In addition, the air guide assembly 150 further includes a driving member 170. The driving member 170 is fixed to the housing 110 and configured to move the linkage mechanism 152.

In some embodiments, the driving member 170 is a lever, which passes through the housing 110 and is exposed (as shown in Fig. 1) for a user to manually move, thereby driving the linkage mechanism 152 to rotate the air guide blades 151.

In other embodiments, the driving member 170 may be a linear motor, such as a stepper motor, but the present disclosure is not limited thereto.

As shown in Fig. 4 and Fig. 5, the driving member 170 is configured to move along the direction D1. The linkage mechanism 152 includes a linkage 152a and a bracket 152b. The second ends 151b of the air guide blades 151 are pivotally connected to the linkage 152a of the linkage mechanism 152. The bracket 152b of the linkage mechanism 152 is connected to the linkage 152a and is configured to slide relative to the driving member 170 along a direction D2.

In detail, the bracket 152b of the linkage mechanism 152 has a through hole 152b1. The driving member 170 is slidably engaged with the through hole 152b1. It can be seen that the bracket 152b will be guided by the driving member 170 to slide along the direction D2.

In practical applications, the through hole 152b1 on the bracket 152b can also be formed on the driving member 170 to allow the bracket 152b to pass through, so as to guide the bracket 152b to slide along the direction D2.

In some embodiments, the direction D2 and the direction D1 are perpendicular to each other, but the disclosure is not limited thereto. In fact, the direction D2 in which the bracket 152b of the linkage mechanism 152 slides relative to the driving member 170 is determined by an extending direction of the driving member 170. Therefore, when the extending direction of the driving member 170 is not perpendicular to the direction D1, the direction D2 is not perpendicular to the direction D1. Generally speaking, when the driving member 170 moves along the direction D1, the bracket 152b of the linkage mechanism 152 will move toward or away from the first ends 151a of the air guide blades 151.

As shown in Fig. 4 and Fig. 5, the driving member 170 has two retaining protrusions 171. The two retaining protrusions 171 are located in the internal space S of the housing 110. The bracket 152b is slidably retained between the two retaining protrusions 171. By limiting the movement range of the bracket 152b of the linkage mechanism 152 relative to the driving member 170 in the direction D2, the movement ranges of the second ends 151b of the air guide blades 151 and the air outlet area AZ in the direction D1 can be limited through the linkage 152a of the linkage mechanism 152. In addition, the two retaining protrusions 171 can also prevent the driving member 170 from passing through the housing 110 and to be pulled out of the housing 110.

The two retaining protrusions 171 of the driving member 170 shown in Fig. 4 and Fig. 5 are located on the same side of the driving member 170, but the present disclosure is not limited thereto. In practical applications, the two retaining protrusions 171 of the driving member 170 may be located on opposite sides of the driving member 170, respectively.

In addition, in an embodiment in which the through hole 152b1 on the bracket 152b is instead formed on the driving member 170 for the bracket 152b to pass through, the bracket 152b can be directly retained by two ends of the through hole 152b1 on the driving member 170, and the two retaining protrusions 171 originally disposed on the driving member 170 can be eliminated.

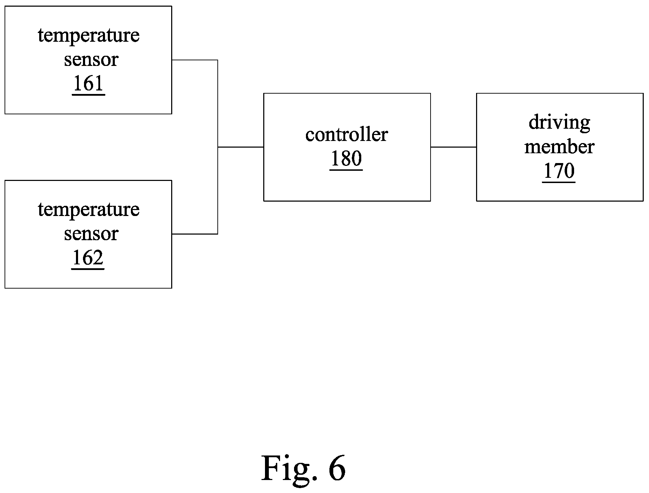

Reference is made to Fig. 6. Fig. 6 is a functional block diagram of some components of the electronic device 100 shown in Fig. 1. The electronic device 100 shown in Figs. 2 to 4 further includes two temperature sensors 161, 162, a driving member 170, and a controller 180. The two temperature sensors 161, 162 are disposed in the housing 110 and are configured to detect temperatures of the two heat sources 141, 142, respectively. The controller 180 is electrically connected to the two temperature sensors 161, 162 and the driving member 170, and is configured to drive the driving member 170 according to the temperatures of the two heat sources 141, 142. In other words, the controller 180 can control the driving member 170 to adjust the air outlet area AZ of the air guide blades 151 through the linkage mechanism 152 according to the temperatures of the two heat sources 141, 142, thereby achieving the effect of automatically dissipating heat in response to the heat of the two heat sources 141, 142.

In some embodiments, the ratio of the two heights H1, H2 of the air outlet area AZ relative to the opposite sides of the partition 130 can be simply regarded as the air volume ratio of the first sub-airflow AF1 and the second sub-airflow AF2 that enter the first sub-space S1 and the second sub-space S2 respectively. The controller 180 is configured to drive the driving member 170 such that a difference percentage between the two heights H1, H2 is substantially equal to a difference percentage between the temperatures of the two heat sources 141, 142. For example, the temperatures of the two heat sources 141, 142 are 60 degrees Celsius and 40 degrees Celsius respectively, and the temperature difference percentage is (60-40)/40 = 50%. The controller 180 can correspondingly drive the driving member 170 to rotate the air guide blades 151 to adjust the difference percentage between the heights H1, H2 to 50%. That is, make the height H1 50% greater than the height H2. The adjustment achieves the purpose of automatically dissipating heat in response to the heat of the two heat sources 141, 142. However, the rules according to which the controller 180 drives the driving member 170 to adjust the rotation of the air guide blades 151 are not limited to this embodiment. For example, in other embodiments, the controller 180 can also adjust the rotation angle of the air guide blades 151 based on the temperatures of the two heat sources 141, 142, thereby achieving the purpose of automatically adjusting the air volumes of the first sub-airflow AF1 and the second sub-airflow AF2.

According to the foregoing recitations of the embodiments of the disclosure, it can be seen that in the electronic device of the present disclosure, before the airflow generated by the fan module reaches the two heat sources respectively disposed in the first sub-space and the second sub-space, the air guide blades of the air guide assembly can rotate to adjust the air volumes of the first sub-airflow and the second sub-airflow entering the first sub-space and the second sub-space respectively, thereby efficiently dissipating heat in response to the heat of the two heat sources. In addition, the controller can control the driving member to adjust the air outlet area of the air guide blades according to the temperatures of the two heat sources (obtained by the two temperature sensors), thereby achieving the effect of automatically dissipating heat in response to the heat of the two heat sources.

## Claims

1. An electronic device (100), **characterized by** comprising:
a housing (110) having an internal space (S) and an opening (OP) communicated with each other;
a fan module (120) fixed to an outside of the housing (110) and configured to generate an airflow (AF) toward the opening (OP);
a partition (130) disposed in the internal space (S), wherein the partition (S) divides the internal space (S) into a first sub-space (S1) and a second sub-space (S2), and is configured to branch the airflow (AF) into a first sub-airflow (AF1) and a second sub-airflow (AF2) to the first sub-space (S1) and the second sub-space (S2), respectively;
two heat sources (141, 142) respectively disposed in the first sub-space (S1) and the second sub-space (S2); and
an air guide assembly (150) disposed at the opening (OP) and comprising a plurality of air guide blades (151), wherein the air guide blades (151) are configured to rotate to adjust air volumes of the first sub-airflow (AF1) and the second sub-airflow (AF2).

2. The electronic device (100) of claim 1, wherein the air guide blades (151) are sequentially arranged along a direction (D1).

3. The electronic device (100) of claim 1 or 2, wherein each of the air guide blades (151) has a first end and (151a) a second end (151b), and the first end (151a) and the second end (151b) are adjacent to the fan module (120) and the partition (130), respectively.

4. The electronic device (100) of claim 3, wherein the second ends (151b) of the air guide blades (151) define an air outlet area (AZ), the air outlet area (AZ) has two heights (H1, H2) relative to opposite sides of the partition (130), respectively, in a direction (D1) perpendicular to a length direction of the partition (130), and the air guide blades (151) are configured to rotate to adjust the two heights (H1, H2).

5. The electronic device (100) of claim 3 or 4, further comprising:
two temperature sensors (161, 162) disposed in the housing (110) and configured to detect temperatures of the two heat sources (141, 142), respectively;
a driving member (170) configured to rotate the air guide blades (151); and
a controller (180) configured to drive the driving member (170) according to the temperatures of the two heat sources (141, 142).

6. The electronic device (100) of claim 5, wherein the second ends (151b) of the air guide blades (151) define an air outlet area (AZ), the air outlet area (AZ) has two heights (H1, H2) relative to opposite sides of the partition (130), respectively, in a direction (D1) perpendicular to a length direction of the partition (130), and the controller (180) is configured to drive the driving member (170) such that a difference percentage between the two heights (H1, H2) is substantially equal to a difference percentage between the temperatures of the two heat sources (141, 142).

7. The electronic device (100) of any of claims 3 to 6, wherein the first end (151a) is pivotally connected to the housing (110), the air guide assembly (150) further comprises a linkage mechanism (152), and the second end (151b) is pivotally connected to the linkage mechanism (152).

8. The electronic device (100) of claim 7, wherein the air guide assembly (150) further comprises a driving member (170), and the driving member (170) is fixed to the housing (110) and configured to move the linkage mechanism (152).

9. The electronic device (100) of claim 8, wherein the driving member (170) is configured to move along a first direction (D1), and the linkage mechanism (170) comprises:
a linkage (152a), wherein the second end (151b) is pivotally connected to the linkage (152a); and
a bracket (152b) connected to the linkage (152a) and configured to slide relative to the driving member (170) along a second direction (D2).

10. The electronic device (100) of claim 9, wherein the bracket (152b) has a through hole (152b1), and the driving member (170) is slidably engaged with the through hole (152b1).

11. The electronic device (100) of claim 9 or 10, wherein the driving member (170) has two retaining protrusions (171), and the bracket (152b) is slidably retained between the two retaining protrusions (171).

12. An electronic device (100), comprising:
a housing (110) having an internal space (S) and an opening (OP) communicated with each other;
a fan module (120) fixed to an outside of the housing (110) and configured to generate an airflow (AF) toward the opening (OP);
a partition (130) dividing the internal space (S) into a first sub-space (S1) and a second sub-space (S2);
two heat sources (141, 142) respectively disposed in the first sub-space (S1) and the second sub-space (S2); and
an air guide assembly (150) disposed at the opening (OP) and comprising a plurality of air guide blades (151), wherein ends (151b) of the air guide blades (151) adjacent to the partition (130) define an air outlet area (AZ), the air outlet area (AZ) has two heights (H1, H2) relative to opposite sides of the partition (130), respectively, in a direction (D1) perpendicular to a length direction of the partition (130), and the air guide blades (151) are configured to rotate to adjust the two heights (H1, H2).

13. The electronic device (100) of claim 12, further comprising:
two temperature sensors (161, 162) disposed in the housing (110) and configured to detect temperatures of the two heat sources (141, 142), respectively;
a driving member (170) configured to rotate the air guide blades (151); and
a controller (180) configured to drive the driving member (170) according to the temperatures of the two heat sources (141, 142).

14. The electronic device (100) of claim 13, wherein the controller (180) is configured to drive the driving member (170) such that a difference percentage between the two heights (H1, H2) is substantially equal to a difference percentage between the temperatures of the two heat sources (141, 142).

15. The electronic device (100) of any of claims 12 to 14, wherein the air guide assembly (150) further comprises a linkage mechanism (152), and the ends (151b) of the air guide blades (151) adjacent to the partition (130) are pivotally connected to the linkage mechanism (152).
